# EUROPÄISCHE PATENTSCHRIFT

(11) **EP 2 110 950 B1**
(45) Veröffentlichungstag und Bekanntmachung des Hinweises auf die Patenterteilung: **25.06.2014**
(21) Anmeldenummer: 09002484.5
(22) Anmeldetag: 21.02.2009
(51) Int. Cl.: H03K 17/56, H03K 19/018

(54) **Schaltung und Verfahren zur Signalspannungsübertragung innerhalb eines Treibers eines Leistungshalbleiterschalters**
Switch and method for transferring signal voltage within a driver of a voltage semiconductor
Circuit et procédé de transmission de tension de signal à l'intérieur d'un pilote d'un circuit semi-conducteur de puissance

(30) Priorität: 28.02.2008 DE 102008011603
(43) Veröffentlichungstag der Anmeldung: 21.10.2009
(73) Patentinhaber: SEMIKRON Elektronik GmbH & Co. KG, 90431 Nürnberg (DE)
(72) Erfinder: Bittner, Roland, 96135 Stegaurach (DE); Hopperdietzel, Rene, 90419 Nürnberg (DE); Suchan, Alexander, 90431 Nürnberg (DE)

(56) Entgegenhaltungen:
- US-A1- 2001 045 845
- US-A1- 2003 012 040
- US-A1- 2005 057 871

## Beschreibung

Die Erfindung betrifft eine Schaltung und ein Verfahren zur Signalspannungsübertragung innerhalb eines Treibers eines Leistungshalbleiterschalters.

Ein Leistungshalbleiterschalter benötigt zu seiner Ansteuerung einen sogenannten Treiber. Dieser Treiber weist eine Primärseite und eine von dieser bezüglich ihres elektrischen Potentials abgegrenzte Sekundärseite auf. An der Primärseite wird in den Treiber, z.B. von einer Standard-5V-Logikschaltung, welche als Bezugspotential zusammen mit der Primärseite z.B. die Anlagenmasse aufweist, eine Signalspannung in Form eines Ein-/Ausschaltsignals für den Leistungshalbleiterschalter gespeist.

Die Sekundärseite und damit der Halbleiterschalter liegt mit ihrem Bezugspotential auf dem Potential des Leistungshalbleiterschalters, z.B. 10 V oberhalb der Anlagenmasse. Insbesondere beim Schaltvorgang des Halbleiterschalters kann das Bezugspotential der Sekundärseite bzw. des Halbleiterschalters stark nach oben oder unten schwanken. Somit besteht zwischen Primär- und Sekundärseite eine Potentialdifferenz. Bei Leistungshalbleiterschaltern niedriger Leistungsklassen, welche z.B. in Gabelstaplern Verwendung finden, beträgt hierbei die maximale Potentialdifferenz zwischen Primär- und Sekundärseite z.B. 200 V.

Zur direkten Ansteuerung des Halbleiterschalters ist sekundärseitig eine (leistungsstärkere und z.B. höhere) Schaltspannung nötig, als primärseitig zur Verfügung steht. Das Schaltsignal bzw. die Schaltspannung muss also innerhalb des Treibers von der Primär- zur Sekundärseite, also über die Potentialgrenze hinweg, übertragen und ggf. verstärkt bzw. modifiziert werden. Hierzu sind verschiedene Lösungen bekannt.

Bekannt ist die direkte Übertragung der Ansteuerleistung durch einen Leistungspuls über einen Transformator, d.h. das Schaltsignal an sich wird über einen Transformator von der Primärzur Sekundärseite übertragen. Der sekundärseitige Schalteingang, also z.B. das Gate des Leistungshalbleiterschalters, ist hierbei z.B. direkt mit dem Transformatorausgang verbunden.

Bekannt ist auch die transformatorische Übertragung von Ansteuerpulsen in Verbindung mit einem sekundärseitigen Flankenspeicher. Hierbei wird aus einem primärseitigen Logiksignal mit den Schaltzuständen Hi und Lo z.B. durch einen Kondensator als Differenzierer für jede Zustandsänderung des Signals (Hi-Lo oder Lo-Hi) ein Puls unterschiedlicher Polarität erzeugt. Der Puls wird über einen HF-Transformator von der Primär- zur Sekundärseite übertragen. Auf der Sekundärseite befindet sich ein Flankenspeicher, z.B. in Form eines Flip-Flops, der durch Pulse der einen Polarität gesetzt und durch die der anderen Polarität gelöscht wird, und somit ein dem Eingangssignal entsprechendes Logiksignal bereitstellt. Hier wird also nicht das Schaltsignal an sich, sondern lediglich dessen Zustandswechsel über den Transformator übertragen und der Schaltzustand, also Ein oder Aus, des Leistungshalbleiterschalters im sekundärseitigem Flankenspeicher gespeichert.

Bekannt ist auch die kapazitive Übertragung von Pulsen mit ausgangsseitigem Flankenspeicher. Hierbei wird aus dem o.g. Logiksignal für dessen jeweilige Zustandsänderung ein Strompuls unterschiedlicher Polarität erzeugt. Der Puls wird über einen bzw. den genannten Kondensator von der Primär- zur Sekundärseite übertragen. Der genannte Flankenspeicher wird entsprechend zu oben durch die Strompulse, bzw. den jeweiligen von diesen an einem Widerstand erzeugten Spannungsabfall angesteuert.

Schließlich ist die Übertragung von Spannungs- und/oder Strompulsen mit sekundärseitigem Flip-Flop-Speicher bekannt, bei der aus dem o.g. Logiksignal ein Strompuls erzeugt wird, der über einen Hochvolttransistor auf die Sekundärseite übertragen wird und dort wieder z.B. das o.g. Flip-Flop ansteuert.

Bekannt ist auch, Schaltimpulse zu kodieren, z.B. mit Hilfe einer Frequenzkodierung, und auf der Sekundär- bzw. Ausgangsseite zu dekodieren. Aus dem genannten Logiksignal werden hierbei je nach Logikzustand bzw. Zustandswechsel des Signals durch eine Kodiereinheit Pulse z.B. unterschiedlicher Frequenz erzeugt. Die Übertragung der Pulse zur Ausgangsseite erfolgt wieder über einen HF-Transformator. Auf der Sekundärseite befindet sich dann wieder eine Dekodierlogik, die durch die Pulse z.B. unterschiedlicher Frequenz gesetzt bzw. rückgesetzt wird und so wieder das o.g. Ausgangssignal bereitstellt.

Aus der US 2003/0012040 A1 ist eine Pegelverschiebungsumkehrschaltung bekannt, welche dazu dient, ein Spannungssignal von einer Hochspannungsseite zu einer Niederspannungsseite einer Leistungshalbleitervorrichtung zu übertragen. Eine auf das hohe Potential bezogene Eingangsspannung wird in einen Strom gewandelt, dieser über eine Potentialdifferenz zu einem Bezugspotential übertragen und dort in eine Spannung zurückgewandelt.

Aus der US 2001/0045845 A1 sind eine LSI-Schaltungen mit unterschiedlichen Spannungsversorgungen bekannt. Hierbei sind beide sog. LSI's auf gleiches Grundpotential geschalten und wandeln das die Versorgungsspannung in einen korrelierten Strom für die Sekundärseite um. Der LSI der Sekundärseite wandelt den übertragenen Strom in eine zweite Spannung um.

Aus der US 2005/0057871 A1 ist ein Schaltungsaufbau bekannt der ein analoges Signal von einem Chip zum anderen Chip übertragt. Dabei weist jeder Chip einen digitalen Signaleingang auf je ein Sende-/Empfangsgerät, damit zwischen den Chips ein analoges Signal gesendet werden kann.

Die bekannten Lösungen weisen allesamt Nachteile auf. Für transformatorische Übertragungsformen sind große induktive Bauteile nötig, die meist mit großen Wertetoleranzen behaftet sind. Allen Pulsübertragungsmethoden ist gemein, dass eine fehlerhafte Übertragung eines Pulses, z.B. durch eine Störung während der Pulsübertragung zu einem falschen Schaltzustand des Leistungshalbleiterschalters für die gesamte Taktdauer, also bis zum Eintreffen des nächsten Pulses führen kann. Sekundärseite Zustandsspeicher, wie z.B. Flankenspeicher oder Flip-Flops bergen stets die Gefahr, dass durch eine kurze Störung, sowohl bei der Ansteuerung solcher Zustandsspeicher als auch im Zustandsspeicher selbst, ein längerfristiger fehlerhafter Schaltzustand des Leitungshalbleiterschalters entsteht, bis der Zustandsspeicher durch einen korrekten Puls bzw. eine korrekte Information wieder in den korrekten Schaltzustand geschaltet wird.

Aufgabe der Erfindung ist es, eine verbesserte Schaltung und ein verbessertes Verfahren zur Signalspannungsübertragung innerhalb eines Treibers eines Leistungshalbleiterschalters anzugeben.

Hinsichtlich der Schaltung wird die Aufgabe gelöst durch eine Schaltung, welche innerhalb eines Treibers eines Leistungshalbleiterschalters eine Signalspannungsübertragung ermöglicht. Die Schaltung enthält einen Signaleingang für eine erste Signalspannung, also für das von der oben genannten Ansteuerlogik in den Treiber bzw. dessen Primärseite eingespeiste Schaltsignal. Der Signaleingang ist an der Primärseite des Treibers angeordnet, wobei die Primärseite ein erstes Bezugspotential aufweist. Mit anderen Worten sind die elektronischen Einbauten der Primärseite auf dieses Bezugspotential, z.B. die Gerätemasse eines gesamten Schaltmoduls oder der Anlage, in die der Treiber eingebaut ist, bezogen.

Die Schaltung umfasst weiterhin eine ebenfalls auf der Primärseite des Treibers angeordnete Stromquelle. Die Stromquelle dient zur Erzeugung eines Stromes, wobei dieser bzw. dessen Stromstärke mit der ersten Signalspannung, also deren Spannungswert, korreliert ist. Aufgrund der Korrelation trägt also der von der Stromquelle erzeugt Strom den Informationsgehalt der Signalspannung, z.B. fließt im einfachsten Fall ein definierter Strom, wenn eine Signalspannung anliegt und kein Strom, wenn keine Signalspannung anliegt.

Die Schaltung umfasst zusätzlich eine Verbindungsleitung, welche von der Primär- zur Sekundärseite des Treibers führt. Die Sekundärseite des Treibers weist hierbei auf ein zweites, in der Regel vom ersten unterschiedliches Bezugspotential auf. Die Verbindungsleitung überbrückt also die Potentialdifferenz bzw. Potentialgrenze zwischen Primär- und Sekundärseite. Auf der Primärseite ist die Verbindungsleitung an die Stromquelle angeschlossen, und führt daher den jeweils von der Stromquelle erzeugten Strom, welcher nun gleichermaßen Primärseite und Sekundärseite durchströmt. Über die Stromstärke wird somit die Information der ersten Signalspannung auf die Sekundärseite transportiert.

Die Schaltung enthält weiterhin einen auf der Sekundärseite angeordneten Strom-Spannungs-Wandler, welcher ebenfalls an die Verbindungsleitung angeschlossen ist und damit vom Strom der Stromquelle durchflossen ist. Der Strom-Spannungswandler dient zur Wandlung des Stromes in eine zweite Signalspannung, welche wiederum mit dem Strom und damit mit der ersten Signalspannung korreliert ist. Zuletzt umfasst die Schaltung einen Signalausgang auf der Sekundärseite des Treibers, an welchem die zweite Signalspannung zur Weiterleitung an den Halbleiterschalter ausgegeben wird.

Mit anderen Worten wird also erfindungsgemäß innerhalb des Treibers eine Signalspannung von der Primär- zur Sekundärseite derart übertragen, dass auf der Primärseite die erste Signalspannung in einen Strom gewandelt, dieser über die Potentialgrenze auf die Sekundärseite transportiert und dort in eine von der ersten abhängige zweite Signalspannung rückgewandelt wird.

Die erfindungsgemäße Schaltung erlaubt eine störsichere Signalübertragung über Potentialgrenzen hinweg. Die Schaltung lässt sich mit wenigen Bauteilen realisieren und ist daher einfach und kostengünstig.

Die primärseitige Stromquelle kann insbesondere eine Stromsenke sein, d.h. auch einen gezielt gesteuerten Stromfluss von der Sekundärseite zur Primärseite ermöglichen bzw. erzeugen, was sich aufgrund der in der Regel von der Sekundärseite zur Primärseite abfallenden Potentialdifferenz anbietet.

In einer vorteilhaften Ausgestaltung der Schaltung ist die Stromquelle mit ihrer einen Seite an die Verbindungsleitung und mit ihrer anderen, also der der Verbindungsleitung abgewandten Seite, am ersten Bezugspotential der Primärseite angeschlossen. Die Stromquelle bewirkt also einen Stromfluss zum Bezugspotential der Primärseite hin bzw. aus diesem heraus. Insbesondere wenn die Potentiale der Sekundärseite höher als das Bezugspotential der Primärseite sind, hat die Stromquelle somit die maximal verfügbare Potentialdifferenz zum Treiben eines Stromes zur Verfügung.

In einer weiteren vorteilhaften Ausgestaltung ist der Signaleingang der Primärseite auf das erste Bezugspotential bezogen.

Dies erleichtert im allgemeinen den Anschluss an eine externe Steuerlogik, da diese in der Regel das gleiche Bezugspotential wie die Primärseite aufweist. Die erste Signalspannung kann so direkt in den Treiber eingespeist werden.

Insbesondere ergibt sich eine besonders einfache Ausführungsform der Erfindung, wenn sowohl die Stromquelle als auch der Signaleingang auf das Bezugspotential bezogen sind. In einer weiteren bevorzugten Ausführungsform kann dann nämlich die Stromquelle eine von der Signalspannung gesteuerte, den Signaleingang direkt aufweisende, in der Regel dreipolige, gesteuerte Stromquelle sein. Eine derartige Stromquelle kann z.B. leicht als Transistorstromquelle realisiert werden, welche beispielsweise einen Widerstand als Gegenkopplung aufweist und so die erste Signalspannung direkt in den Strom wandelt.

Eine derartige Transistorstromquelle kann noch durch ein basisseitiges RC-Filter und/oder eine Klemmdiode ergänzt sein, um eine eingangsseitige Tiefpassfilterung der Signalspannung und/oder einen Überspannungsschutz etc. zu bewirken.

In einer weiteren bevorzugten Ausführungsform ist die Stromquelle eine spannungsfeste Stromquelle welche mit mindestens der maximalen Spannungsdifferenz zwischen Primär- und Sekundärseite belastbar ist. Somit übernimmt die Stromquelle die Trennung bzw. das Auffangen der Potentialdifferenz zwischen Primär- und Sekundärseite. Sonstige Vorkehrungen zur Potentialüberwindung zwischen Primär- und Sekundärseite müssen so nicht getroffen werden.

Eine besonders einfache Ausführungsform einer spannungsfesten Stromquelle ergibt sich, wenn die Stromquelle einen an die Verbindungsleitung angeschlossenen, spannungsfesten Hochvolttransistor enthält. Der Potentialschutz zwischen Primär- und Sekundärseite wird somit durch dieses eine Bauteil bewerkstelligt.

In einer weiteren bevorzugten Ausführungsform ist der Verbindungsleitung ein zwischen Primär- und Sekundärseite wirkender Verpolschutz und/oder eine zwischen den beiden Seiten wirkender Strombegrenzer zugeordnet. Der Verpolschutz sorgt z.B. dafür, dass kein Strom in unerlaubter Richtung durch die Stromquelle oder den Strom-Spannungswandler fließen kann. Der Strombegrenzer sorgt bei entsprechend großen Potentialdifferenzen zwischen Primär- und Sekundärseite für eine Begrenzung des maximal zulässigen, in der Verbindungsleitung und damit durch Stromquelle und Strom-Spannungswandler fließenden Stromes. Diese beiden Komponenten der Schaltung sind durch die entsprechenden Maßnahmen also geschützt.

In einer weiteren bevorzugten Ausführungsform ist der Verpolschutz eine in der Verbindungsleitung angeordnete Diode und/oder der Strombegrenzer ein in dieser angeordneter Widerstand.

Der Strombegrenzungswiderstand und /oder die Verpolschutzdiode bedämpfen somit die parasitären Effekte schneller Potentialverschiebungen zwischen Primär- und Sekundärseite.

In einer weiteren bevorzugten Ausführungsform der Schaltung ist der Strom-Spannungs-Wandler mit seiner der Verbindungsleitung abgewandten Seite an die Versorgungsspannung der Sekundärseite angeschlossen. Mit anderen Worten fließt der Strom von der Verbindungsleitung durch den Strom-Spannungs-Wandler so zur Versorgungsspannung der Sekundärseite. Somit ergeben sich sekundärseitig die entsprechenden Vorteile wie beim Anschluss der Stromquelle an das Bezugspotential der Primärseite, nämlich eine maximal mögliche Spannungsdifferenz zwischen den jeweiligen Enden des Pfades für den Strom, insbesondere wenn der Strom von der Sekundär- zur Primärseite fließt bzw. die Versorgungsspannung der Sekundärseite ein gegenüber dem Bezugspotential der Primärseite maximales Potential aufweist.

In einer weiteren bevorzugten Ausführungsform ist der Signalausgang der Sekundärseite auf das zweite Bezugspotential bezogen. Die zweite Signalspannung kann somit analog zur ersten in eine weiter verarbeitende Logik der Sekundärseite auf einfache Weise ohne Potentialumwandlung eingespeist werden.

In Verbindung mit einem Strom-Spannungs-Wandler, welcher an der Versorgungsspannung der Sekundärseite angeschlossen ist, ist hierbei jedoch eine Umsetzung des Stromes bzw. der aus diesem gewinnbaren Spannung, die dann in der Regel auf die Versorgungsspannung bezogen sind, in die auf das Bezugspotential bezogenen zweiten Signalspannung notwendig.

Der Strom-Spannungs-Wandler enthält einen Stromspiegel, der den von der Verbindungsleitung kommenden Strom in einen Spiegelstrom, d.h. in einen weiteren mit dem Strom korrelierten Strom, der dann wiederum in die zweite Signalspannung zu wandeln ist. In einer derartigen beispielhaften Konfiguration fließt dann der von der Primärseite zur Sekundärseite übertragene Strom von der Versorgungsspannung der Sekundärseite durch den Stromspiegel, die Verbindungsleitung und die Stromquelle zum Bezugspotential der Primärseite. Der Spiegelstrom fließt von der Versorgungsspannung der Sekundärseite zum Bezugspotential der Sekundärseite. Der Spiegelstrom selbst ist dann leicht in eine auf das Bezugspotential der Sekundärseite bezogene zweite Signalspannung wandelbar.

Der Stromspiegel kann ein Transistorstromspiegel sein, welcher beispielsweise zusätzlich Widerstände als Emittergegenkopplung zur Strombegrenzung enthalten kann.

Um eine besonders einfache Strom-Spannungs-Umsetzung für die zweite Signalspannung zur realisierenden, kann der Strom-Spannungs-Wandler einen den Strom in die zweite Signalspannung umsetzenden Widerstand enthalten.

Für eine erfindungsgemäße Schaltung kann es auch erwünscht sein, dass Signalwechsel, also Änderungen der Signalspannung in zeitlichen Abständen, welche deutlich kürzer sind als die typischen Schaltzeiten, unterdrückt werden. Derartig kurzfristige Signalschwankungen können z.B. durch Schwankungen der ersten Signalspannung, Schwankungen des Stromes auf Grund der Spannungsdrift der Sekundärseite oder ähnliches entstehen. In einer weiteren bevorzugten Ausführungsform ist daher in der Schaltung ein Dämpfungsglied für die zweite Signalspannung vorhanden, welches lediglich beispielsweise zum Abfangen von Schwankungen des Stromes dient, welche zur ersten Signalspannung unkorreliert sind, also beispielsweise durch die oben genannten Potentialdrift entstehenden. Entsprechende Dämpfungsglieder sind z.B. Tiefpassfilter, die der Stromquelle, der Verbindungsleitung, dem optionalen Stromspiegel oder dem Strom-Spannungs-Wandler zugeordnet sind.

Werden die entsprechenden Filterelemente zur Bedämpfung parasitärer Effekte entsprechend reduziert bzw. in ihren Zeitkonstanten gesenkt, eignet sich die erfindungsgemäße Schaltung neben der Übertragung von vergleichsweise langsamen Signalen zum Schalten des Leistungshalbleiterschalters auch für die Übertragung eines schnellen Datenübertragungsprotokolls. Somit können neben Schaltsignalen auch andere, z.B. umfangreiche Informationen wie Steuersignale oder Programmcode, durch die Signalspannungen von der Primär- zur Sekundärseite des Treibers übertragen werden.

In einer besonders bevorzugten Ausführungsform ist das Dämpfungsglied ein Kondensator, an dem die zweite Signalspannung anliegt. Mit anderen Worten verfügt der Signalausgang auf der Sekundärseite über einen Kondensator.

Durch den dem Signalausgang parallel geschalteten Kondensator wird also die zweite Signalspannung gefiltert, wodurch sich eine berechenbare Mindesteinschaltdauer für den Leistungshalbleiterschalter, also eine Kurzimpulsunterdrückung und insgesamt eine erhöhte Störfestigkeit der Schaltung ergeben.

Die Schaltung zwischen Signaleingang und Strom-Spannungswandler enthält jeweils zwei Stromquellen und zwei Verbindungsleitungen. Je eine Stromquelle und eine Verbindungsleitung zusammen bilden so einen separaten Signal- bzw. Strompfad zwischen Signaleingang und Strom-Spannungswandler. Der eine Signalpfad wird benutzt, wenn das Bezugspotential der Sekundärseite höher als das der Primärseite ist. Der Strom fließt dann physikalisch gesehen von der Sekundärseite zur Primärseite, obschon die Information in Gegenrichtung transportiert wird. Der andere Signalpfad wird dann benutzt, wenn das Bezugspotential der Sekundärseite niedriger als das der Primärseite ist. Der Strom fließt dann physikalisch gesehen von der Primärseite zur Sekundärseite, also in die gleiche Richtung, in die die Information transportiert wird.

Somit wird für erfindungsgemäße Schaltung also ein zweiter Signalpfad zwischen Primär- und Sekundärseite zur Verfügung gestellt, der eine zum ersten Signalpfad komplementäre Stromrichtung aufweist und damit ein physikalisch komplementäres Signal tragen kann. Beide Signalpfade sind dabei derart logisch miteinander verschaltet, dass externe Einflüsse, wie z.B. eine sekundärseitige Potentialschwankung, die dieses von oberhalb nach unterhalb des primärseitigen Bezugspotentials bringt, kompensiert werden. Eine derartige Schwankung führt dann nicht mehr zum Abriss des physikalischen Stromflusses und einer damit verbundenen Verfälschung des Ausgangssignals, sondern dazu, dass der Stromfluss auf den alternativen Strompfad ausweicht, wobei der logische Signalfluss von der Primärzur Sekundärseite korrekt erhalten bleibt.

Hinsichtlich des Verfahrens wird die Aufgabe gelöst durch ein Verfahren zur Signalspannungsübertragung innerhalb eines Treibers eines Leistungshalbleiterschalters mit folgenden Schritten: Am oben genannten Signaleingang der Primärseite des Treibers wird die erste Signalspannung angelegt, die erste Stromquelle erzeugt den mit der Signalspannung korrelierten Strom, die Verbindungsleitung führt den Strom von der Primär- zur Sekundärseite, der Strom-Spannungswandler wandelt den Strom in die zweite Signalspannung und diese wird am Signalausgang ausgegeben.

Die Vorteile des erfindungsgemäßen Verfahrens wurden bereits im Zusammenhang mit der erfindungsgemäßen Schaltung erläutert.

Wie bereits erwähnt, fließt bei einer bevorzugten Ausführungsform des Verfahrens der Strom von der Versorgungsspannung der Sekundärseite zum Referenzpotential der Primärseite.

Wie ebenfalls erwähnt, wird bei einer weiteren bevorzugten Ausführungsform des Verfahrens der auf der Sekundärseite ankommende Strom von einem Stromspiegel in einem zum ankommenden Strom korrelierten Spiegelstrom übersetzt und der Spiegelstrom anstelle des eigentlichen Stromes dem Strom-Spannungs-Wandler zugeführt. Der Strom-Spannungs-Wandler wandelt dann den Spiegelstrom in die zweite Signalspannung.

Wir bereits erwähnt, können in bevorzugter Weise auch erste und/oder zweite Signalspannung und/oder der Strom tiefpassgefiltert werden.

Für eine weitere Beschreibung der Erfindung wird auf die Ausführungsbeispiele der Zeichnungen verwiesen. Es zeigen, jeweils in einer schematischen Prinzipskizze:
- Fig.1: das Prinzipbild einer erfindungsgemäßen Schaltung mit Halbleiterschalter und Ansteuerelektronik mit Stromfluss zur Sekundärseite,
- Fig.2: ein konkretes Ausführungsbeispiel der Schaltung aus Fig. 1 mit Stromfluss zur Primärseite.
- Fig.3: eine alternative Ausführungsform zur Schaltung aus Fig.2 mit einem zweiten alternativen Strompfad.

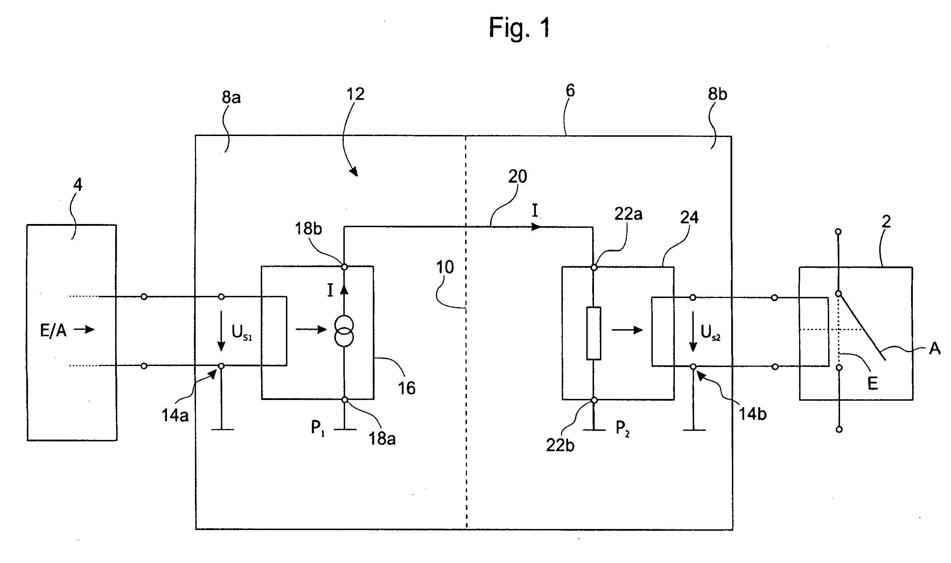

Fig. 1 zeigt als Leistungshalbleiterschalter einen Schalter 2, dessen Schaltzustand "Ein" E und "Aus" A von einer Logikschaltung 4 vorgegeben wird. Die Logikschaltung 4 erzeugt hierzu eine erste Signalspannung U_{S1} welche jedoch zur tatsächlichen Ansteuerung des Schalters 2 nicht ausreicht. Dieser benötigt nämlich eine deutlich stärkere Signalspannung U_{S2}. Zur Erzeugung der Signalspannung U_{S2} aus U_{S1} ist daher zwischen Logikschaltung 4 und Schalter 2 ein Treiber 6 geschaltet, welcher eine zur Logikschaltung 4 weisende Primärseite 8a und eine zum Schalter 2 weisende Sekundärseite 8b aufweist. Primärseite 8a und Sekundärseite 8b weisen, dargestellt durch die gestrichelte Linie 10, Potentialunterschiede auf. Beispielsweise weisen die Primärseite 8a als Masse ein erstes Bezugspotential P₁ und die Sekundärseite 8b ein Bezugspotential P₂ auf.

Der Treiber 6 enthält eine Schaltung 12, welche zur Signalspannungsübertragung der von der Logikschaltung 4 kommenden, auf der Primärseite 8a ankommenden, ersten Signalspannung U_{S1} dient. Diese wird in Form der zweiten Signalspannung U_{S2} zum Schalter 2 auf der Sekundärseite 8b abgegeben. Die Schaltung 12 umfasst einen auf der Primärseite 8a angeordneten, zweipoligen Signaleingang 14a und eine Stromquelle 16, welche einen mit der Signalspannung U_{S1} korrelierten, z.B. zu dieser proportionalen, Strom I erzeugt. Am Signaleingang 14a ist die Logikschaltung 4 angeschlossen.

Die Stromquelle 16 ist mit ihrem ersten Stromanschluss 18a, der den Strom I führt, am Bezugspotential P₁ und mit ihrem zweiten, den Strom I führenden Stromanschluss 18b an einer Verbindungsleitung 20 angeschlossen, welche von der Primärseite 8a über die Potentialgrenze der Linie 10 hinweg zur Sekundärseite 8b führt. Die Verbindungsleitung 20 transportiert also den Strom I zur Sekundärseite 8b.

Auf der Sekundärseite 8b ist die Verbindungsleitung 20 an einen ersten Stromanschluss 22a eines StromSpannungswandlers 24 angeschlossen, wobei der Strom I den Strom-Spannungswandler 24 am Stromanschluss 22b verlässt, welcher zum Bezugspotential P₂ führt. Der Strom-Spannungswandler 24 wandelt den Strom I in eine zweite Signalspannung U_{S2}, welche er an einem zweipoligen Signalausgang 14b zur Verfügung stellt. Am Signalausgang 14b ist der Schalter 2 angeschlossen.

Im Folgenden befindet sich der Schalter 2 zunächst in der Stellung "Aus" A, die Signalspannungen U_{S1} und U_{S2} betragen 0V bezogen auf die jeweiligen Potentiale P₁ und P₂, der Strom I beträgt 0A.

Zum Einschalten des Schalters 2 erzeugt die Logikschaltung 4 eine Spannung U_{S1} von +5V bezogen auf das Bezugspotential P₁. Die Stromquelle 16 liefert daraufhin einen Strom I von beispielhaft 1 mA, welcher im Strom-Spannungswandler 24 in eine zweite Signalspannung U_{S2} von +15V bezüglich des Bezugspotentials P₂ umgesetzt wird, woraufhin der Schalter 2 in den Zustand "Ein" E wechselt. Das Bezugspotential P₁ ist hierbei um eine Spannungsdifferenz von 10V höher als das Bezugspotential P₂, weshalb der Strom I von der Primär- 8a zur Sekundärseite 8b fließt.

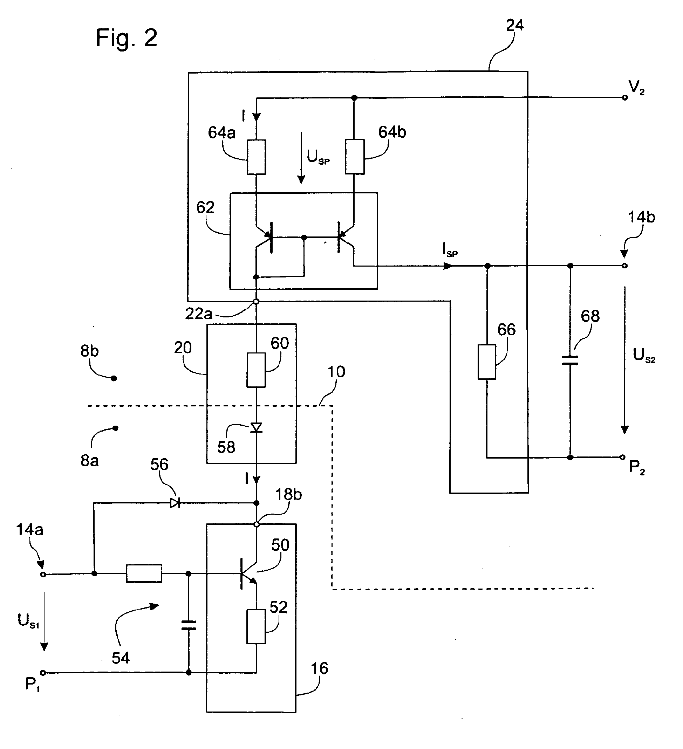

Fig. 2 zeigt eine alternative Ausgestaltung einer Schaltung 12, bei welcher das Bezugspotential P₂ im regulären Betrieb stets höher ist als das Bezugspotential P₁. In Fig. 2 enthält die Stromquelle 16 einen Hochvolttransistor 50, welcher im Beispiel bis 200V spannungsfest ist und damit bezüglich der maximalen Potentialdifferenz zwischen dem Bezugspotential P₁ und der Versorgungsspannung V₂ der Sekundärseite 8b spannungsfest ist. Die Stromquelle 16 enthält außerdem einen am Emitter des Hochvolttransistors 50 angeschlossenen Emitterwiderstand 52 als Emittergegenkopplung. Zwischen dem Signaleingang 14a und der Stromquelle 16 ist außerdem ein RC-Filter 54 geschaltet. Eine Klemmdiode 56 verbindet den Stromanschluss 18b mit dem signalführenden Eingang des Signaleingangs 14a.

Die Verbindungsleitung 20 enthält ebenfalls eine Klemmdiode 58 und als Strombegrenzungswiderstand einen Widerstand 60 zur Strombegrenzung zwischen Sekundärseite 8b und Primärseite 8a. Wegen der gegebenen Potentialdifferenzen der Bezugspotentiale P₂ und P₁ fließt der Strom I in Fig. 2 von der Versorgungsspannung V₂ der Sekundär- 8b zum Bezugspotential P₁ der Primärseite 8a.

Der Strom-Spannungs-Wandler 24 enthält in Fig. 2 einen Stromspiegel 62, welcher intern mit dem Stromanschluss 22a verbunden ist; der Strom I wird also intern über den Stromspiegel 62 und einen Spiegelwiderstand 64a zur Versorgungsspannung V₂ geführt. Im Stromspannungswandler 24 wird daher am Spiegelwiderstand 64a der Strom I zunächst in eine Spiegelspannung U_{SP} gewandelt. Diese ist auf die Versorgungsspannung V₂ bezogen. Prinzipiell könnte die Spiegelspannung U_{SP} bereits als Ausgangsspannung U_{S2} verwendet werden, wenn letztere auf die Versorgungsspannung V₂ der Sekundärseite 8b bezogen sein darf.

Obwohl die Spiegelspannung U_{SP} das logische Schaltsignal für den Schalter 2 trägt, benötigt dieser jedoch im Beispiel eine auf das Bezugspotential P₂ bezogene Schaltspannung. Über den Stromspiegel 62 bzw. einen weiteren Spiegelwiderstand 64b wird daher die Spiegelspannung U_{SP} in einen Spiegelstrom I_{SP} gewandelt, welcher an Stelle des ursprünglichen Stroms I einem Widerstand 66 zugeführt wird, und dort schließlich in die Signalspannung U_{S2} gewandelt wird. Da der Widerstand 66 mit dem Bezugspotential P₂ verbunden ist, ist nun die Signalspannung U_{S2} ebenfalls auf dieses Bezugspotential bezogen und kann so direkt vom Schalter 2 benutzt werden. Zur Tiefpassfilterung der Signalspannung U_{S2} ist dem Widerstand 66 ein Filterkondensator 68 parallel geschaltet, an welchem ebenfalls die Signalspannung U_{S2} abfällt.

In der vorliegenden Schaltung gemäß Fig. 2 sind während des Schaltvorgangs des Schalters 2 auch kurze Spannungsunterschwingungen, d.h. Schwankungen des Potentials P₂ auch unterhalb des Potentials P₁ erlaubt, solange diese die Sperrspannung der Diode 58 nicht unterschreiten. Auch derartige Unterschwingungen werden vom Kondensator 68 abgefiltert, so dass die Signalspannung U_{S2} nicht unter denjenigen Wert fällt oder denjenigen übersteigt, bei welchem der Schalter 2 fälschlicherweise schalten würde.

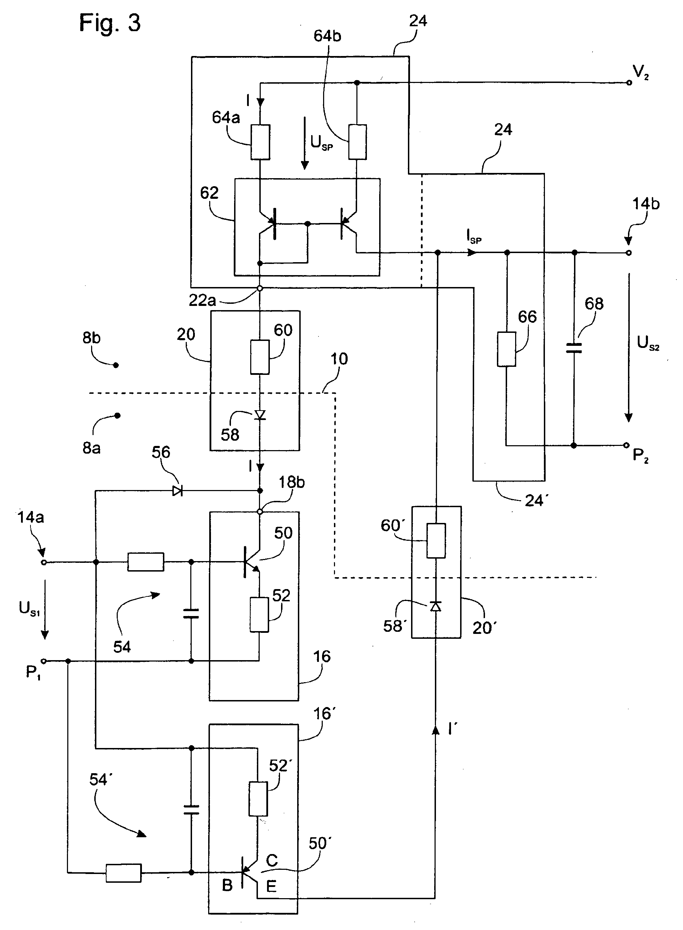

Fig. 3 zeigt, wie am Signaleingang 14a parallel zum RC-Filter 54 ein zweites RC-Filter 54' angeschlossen ist. Dieses ist zum RC-Filter 54 invertiert angeschlossen, d.h. der Widerstand befindet sich in der am Potential P₁ angeschlossenen unteren Leitung. Auch ein entsprechender Hochvolttransistor 50' ist mit seiner Basis B am Potential P₁ und mit seinem Kollektor C über einen Widerstand 52' am RC-Glied 54' angeschlossen, so dass diese eine Stromquelle 16' bilden. Der Emitter E des Hochvolttransistors 50' ist über einen gegenüber der Diode 58 gegenläufig gepolte Diode 58' und einen Widerstand 60' mit dem Widerstand 60 verbunden. So weist Fig. 3 eine zur Verbindungsleitung 20 komplementäre Verbindungsleitung 20' auf, die ebenfalls zwischen Signaleingang 14a und dem Strom-Spannungswandler 24', gebildet aus Widerstand 66 und Kondensator 68, angeschlossen ist. Somit kann in der Schaltung gemäß Fig. 3 ein Strom I oder I' physikalisch zwischen Primär- 8a und Sekundärseite 8b wahlweise über die Verbindungsleitungen 20 oder 20' fließen, je nachdem welches der Bezugspotentiale P1 oder P2 größer als das jeweils andere ist. Der Strompfad 20' umgeht hierbei den Stromspiegel 62, welcher damit nicht zum Strom-Spannungswandler 24' zählt, da der Stromfluss I' primärseitig vom Potential P₁ her erfolgt, und daher nicht benötigt wird.

**Bezugszeichenliste**

| | | | |
|---|---|---|---|
| 2 | Schalter | V₂ | Versorgungsspannung |
| 4 | Logikschaltung | U_{SP} | Spiegelspannung |
| 6 | Treiber | B | Basis |
| 8a | Primärseite | C | Kollektor |
| 8b | Sekundärseite | E | Emitter |
| 10 | Linie | | |
| 12 | Schaltung | | |
| 14a | Signaleingang | | |
| 14b | Signalausgang | | |
| 16 | Stromquelle | | |
| 18a,b | Stromanschluss | | |
| 20,20' | Verbindungsleitung | | |
| 22a,b | Stromanschluss | | |
| 24 | Strom-Spannungswandler | | |
| 50,50' | Hochvolttransistor | | |
| 52,52' | Widerstand | | |
| 54,54' | RC-Filter | | |
| 56,58,58' | Klemmdiode | | |
| 60,60' | Widerstand | | |
| 62 | Stromspiegel | | |
| 64a,b | Spiegelwiderstand | | |
| 66 | Widerstand | | |
| 68 | Kondensator | | |
| | | | |
| E | Ein | | |
| A | Aus | | |
| U_{S1,2} | Signalspannung | | |
| P_{1,2} | Bezugspotential | | |
| I,I' | Strom | | |

## Patentansprüche

1. Schaltung zur Signalspannungsübertragung innerhalb eines Treibers (6) eines Leistungshalbleiterschalters (2), mit:
- einem auf einer ein erstes Bezugspotential (P₁) aufweisenden Primärseite (8a) des Treibers (6) angeordneten Signaleingang (14a) für eine erste Signalspannung (U_{S1}),
- einer auf der Primärseite (8a) angeordneten Stromquelle (16,16') zum Erzeugen eines mit der ersten Signalspannung (U_{S1}) korrelierten Stromes (I,I'),
- einer an der Stromquelle (16,16') angeschlossenen, von der Primär- (8a) zu einer ein zweites Bezugspotential (P₂) aufweisenden Sekundärseite (8b) des Treibers (6) führenden Verbindungsleitung (20,20') zum Führen des Stromes (I,I'),
- einem auf der Sekundärseite (8b) angeordneten, an die Verbindungsleitung (20,20') angeschlossenen Strom-Spannungswandler (24,24') zur Wandlung des Stromes (I,I') in eine mit dem Strom (I,I') korrelierte zweite Signalspannung (U_{S2}),
- einem auf der Sekundärseite (8b) angeordneten Signalausgang (14b) für die zweite Signalspannung (U_{S2}),
**dadurch gekennzeichnet, dass**
- zwischen Signaleingang (14a) und Strom-Spannungswandler (24,24') jeweils Stromquelle (16,16') und Verbindungsleitung (20,20') in doppelter Ausführung vorhanden sind und somit eine erste Stromquelle (16), eine zweite Stromquelle (16'), eine erste Verbindungsleitung (20) und eine zur ersten Verbindungeinrichtung (20) komplementäre zweite Verbindungsleitung (20') vorhanden sind,
- wobei die zweite Stromquelle (16') und die zweite Verbindungsleitung (20') zusammen einen Strompfad zwischen Signaleingang (14a) und Strom-Spannungswandler (24,24') bilden,
- wobei der Strom-Spannungswandler (24) einen Stromspiegel (62) zur Umsetzung des von der ersten Verbindungsleitung (20) kommenden Stromes (I) in einen in die zweite Signalspannung (U_{S2}) zu wandelnden Strom (I_{SP}) enthält, wobei je eine Stromquelle (16,16') zusammen mit einer Verbindungsleitung (20,20') zur Signalübertragung für den jeweiligen Fall dient, dass das erste Bezugspotential (P₁) jeweils kleiner oder größer dem zweiten Bezugspotential (P₂) ist, wobei hierbei der Strompfad den Stromspiegel (62) umgeht.

2. Schaltung nach Anspruch 1, bei der die Stromquelle (16,16') mit ihrer der Verbindungsleitung (20) abgewandten Seite am ersten Bezugspotential (P₁) angeschlossen ist.

3. Schaltung nach Anspruch 1 oder 2, bei der der Signaleingang (14a) auf das erste Bezugspotential (P₁) bezogen ist.

4. Schaltung nach einem der vorhergehenden Ansprüche, bei der die Stromquelle (16,16') eine von der ersten Signalspannung (U_{S1}) gesteuerte, den Signaleingang (14a) aufweisende, gesteuerte Stromquelle ist.

5. Schaltung nach einem der vorhergehenden Ansprüche, bei der die Stromquelle (16,16') eine für mindestens die maximale Spannungsdifferenz zwischen Primär- (8a) und Sekundärseite (8b) spannungsfeste Stromquelle ist.

6. Schaltung nach Anspruch 5, bei der die Stromquelle (16,16') einen an der Verbindungsleitung (20,20') angeschlossenen, spannungsfesten Hochvolttransistor (50,50') enthält.

7. Schaltung nach einem der vorhergehenden Ansprüche, bei der der Verbindungsleitung (20,20') ein zwischen Primär- (8a) und Sekundärseite (8b) wirkender Verpolschutz (58,58') und/oder Strombegrenzer (60,60') zugeordnet ist.

8. Schaltung nach Anspruch 7, bei der der Verpolschutz (58,58') eine Diode und/oder der Strombegrenzer (60,60') ein Widerstand in der Verbindungsleitung (20,20') ist.

9. Schaltung nach einem der vorhergehenden Ansprüche, bei der der Strom-Spannungswandler (24,24') mit seiner der Verbindungsleitung (20,20') abgewandten Seite an die Versorgungsspannung (V₂) der Sekundärseite (8b) angeschlossen ist.

10. Schaltung nach einem der vorhergehenden Ansprüche, bei der der Signalausgang (14b) auf das zweite Bezugspotential (P₂) bezogen ist.

11. Schaltung nach einem der vorhergehenden Ansprüche, bei der der Strom-Spannungswandler (24) einen den Strom (I,I') in die zweite Signalspannung (U_{S2}) umsetzenden Widerstand (66) enthält.

12. Schaltung nach einem der vorhergehenden Ansprüche, mit einem Dämpfungsglied (68) für die zweite Signalspannung (U_{S2}) .

13. Schaltung nach Anspruch 12, bei der das Dämpfungsglied (68) ein Kondensator ist, an dem die zweite Signalspannung (U_{S2}) anliegt.

## Claims

1. A circuit for signal voltage transmission within a driver (6) of a power semiconductor switch (2), with:
- a signal input (14a) for a first signal voltage (U_{S1}) arranged on a primary side (8a) of the driver (6), which has a first reference potential (P₁),
- a current source (16 16') arranged on the primary side (8a) for generating a current (I, I') correlated with the first signal voltage (U_{S1}),
- a connection line (20, 20') for conducting the current (I, I'), which is connected to the current source (16, 16') and leads from the primary (8a) to a secondary side (8b) of the driver (6) having a second reference potential (P₂) .
- a current/voltage transformer (24, 24') arranged on the secondary side (8b) and connected to the connection line (20, 20'), for converting the current (I, I') to a second signal voltage (U_{S2}) correlated with the current (I, I'),
- a signal output (14b) for the second signal voltage (U_{S2}) arranged on the secondary side (8b),
**characterised in that**
- two versions of current source (16, 16') and connection line (20, 20') are in each case present between signal input (14a) and current/voltage transformer (24, 24') and thus a first current source (16), a second current source (16'), a first connection line (20) and a second connection line (20') complementary to the first connection line (20) are present,
- wherein the second current source (16') and the second connection line (20') together form a current path between signal input (14a) and current/voltage transformer (24, 24'),
- wherein the current/voltage transformer (24) contains a current mirror (62) for converting the current (I) coming from the first connection line (20) to a current (I_{SP}) to be converted to the second signal voltage (U_{S2}), wherein each current source (16, 16') is used together with a connection line (20, 20') for signal transmission for the respective case, **in that** the first reference potential (P₁) is in each case smaller or larger than the second reference potential (P₂), wherein the current path bypasses the current mirror (62) here.

2. The circuit according to Claim 1, in which the current source (16, 16') is connected to the first reference potential (P₁) by means of the side thereof facing away from the connection line (20).

3. The circuit according to Claim 1 or 2, in which the signal input (14a) is related to the first reference potential (P₁).

4. The circuit according to one of the preceding claims, in which the current source (16, 16') is a controlled current source, which is controlled by the first signal voltage (U_{S1}) and has the signal input (14a).

5. The circuit according to one of the preceding claims, in which the current source (16, 16') is a current source, which is surge-proof for at least the maximum voltage difference between primary (8a) and secondary side (8b).

6. The circuit according to Claim 5, in which the current source (16, 16') contains a surge-proof high-voltage transistor (50, 50') connected to the connection line (20, 20').

7. The circuit according to one of the preceding claims, in which a reverse polarity safeguard (58, 58') and/or current limiter (60, 60') acting between primary (8a) and secondary side (8b) is assigned to the connection line (20, 20').

8. The circuit according to Claim 7, in which the reverse polarity safeguard (58, 58') is a diode and/or the current limiter (60, 60') is a resistance in the connection line (20, 20').

9. The circuit according to one of the preceding claims, in which the current/voltage transformer (24, 24') is connected by means of the side thereof facing away from the connection line (20, 20') to the supply voltage (V₂) of the secondary side (8b).

10. The circuit according to one of the preceding claims, in which the signal output (14b) is related to the second reference potential (P₂).

11. The circuit according to one of the preceding claims, in which the current/voltage transformer (24) contains a resistance (66) converting the current (I, I') to the second signal voltage (U_{S2}).

12. The circuit according to one of the preceding claims, with an attenuator (68) for the second signal voltage (U_{S2}).

13. The circuit according to Claim 12, in which the attenuator (68) is a capacitor, at which the second signal voltage (U_{S2}) is applied.

## Revendications

1. Circuit pour la transmission de tension de signal à l'intérieur d'un excitateur (6) d'un commutateur à semiconducteur de puissance (2), avec :
- une entrée de signal (14a) pour une première tension de signal (U_{S1}) disposée sur un côté primaire (8a) de l'excitateur (6) présentant un premier potentiel de référence (P₁),
- une source de courant (16, 16') disposée sur le côté primaire (8a) pour la génération d'un courant (I, I') corrélé à la première tension de signal (U_{S1}),
- une ligne de connexion (20, 20') pour la conduction du courant (I, I'), raccordée à la source de courant (16, 16'), allant du côté primaire (8a) à un côté secondaire (8b) de l'excitateur (6) présentant un deuxième potentiel de référence (P₂),
- un convertisseur courant-tension (24, 24') disposé côté secondaire (8b), raccordé à la ligne de connexion (20, 20'), pour la conversion du courant (I, I') en une deuxième tension de signal (U_{S2}) corrélée au courant (I, I'),
- une sortie de signal (14b) pour la deuxième tension de signal (U_{S2}), disposée côté secondaire (8b),
**caractérisé en ce que**
- source de courant (16, 16') et ligne de connexion (20, 20') sont présentées en double entre l'entrée de signal (14a) et le convertisseur courant-tension (24, 24'), et **en ce qu'**une première source de courant (16), une deuxième source de courant (16'), une première ligne de connexion (20) et une deuxième ligne de connexion (20') complémentaire à la première ligne de connexion (20) sont ainsi présentées,
- la deuxième source de courant (16') et la deuxième ligne de connexion (20') formant ensemble un chemin de courant entre l'entrée de signal (14a) et le convertisseur courant-tension (24, 24'),
- le convertisseur courant-tension (24) comprenant un miroir de courant (62) pour la transformation du courant (I) provenant de la ligne de connexion (20) en un courant (I_{SP}) à convertir en deuxième tension de signal (U_{S2}), chaque source de courant (16, 16') servant avec une ligne de connexion (20, 20') à la transmission de signal pour le cas où le premier potentiel de référence (P₁) est inférieur ou supérieur au deuxième potentiel de référence (P₂), le chemin de courant contournant en l'occurrence le miroir de courant (62).

2. Circuit selon la revendication 1, où la source de courant (16, 16') est raccordée au premier potentiel de référence (P₁) par son côté distant de la ligne de connexion (20).

3. Circuit selon la revendication 1 ou 2, où l'entrée de signal (14a) est rapportée au premier potentiel de référence (P₁).

4. Circuit selon l'une des revendications précédentes, où la source de courant (16, 16') est une source de courant commandée par la première tension de signal (U_{S1}), présentant l'entrée de signal (14a).

5. Circuit selon l'une des revendications précédentes, où la source de courant (16, 16') est une source de courant à tension invariable pour au moins le différentiel de tension maximal entre côté primaire (8a) et côté secondaire (8b).

6. Circuit selon la revendication 5, où la source de courant (16, 16') comprend un transistor à haute tension invariable (50, 50') raccordé à la ligne de connexion (20, 20').

7. Circuit selon l'une des revendications précédentes, où une protection contre l'inversion de polarité (58, 58') active entre le côté primaire (8a) et le côté secondaire (8b) et/ou un limiteur de courant (60, 60') sont associés à la ligne de connexion (20, 20').

8. Circuit selon la revendication 7, où la protection contre l'inversion de polarité (58, 58') est une diode et/ou le limiteur de courant (60, 60') est une résistance dans la ligne de connexion (20, 20').

9. Circuit selon l'une des revendications précédentes, où le convertisseur courant-tension (24, 24') est raccordée à la tension d'alimentation (V₂) du côté secondaire (8b) par son côté distant de la ligne de connexion (20, 20').

10. Circuit selon l'une des revendications précédentes, où la sortie de signal (14b) est rapportée au deuxième potentiel de référence (P₂).

11. Circuit selon l'une des revendications précédentes, où le convertisseur courant-tension (24) comprend une résistance (66) transformant le courant (I, I') en deuxième tension de signal (U_{S2}).

12. Circuit selon l'une des revendications précédentes, avec un atténuateur (68) pour la deuxième tension de signal (U_{S2}).

13. Circuit selon la revendication 12, où l'atténuateur (68) est un condensateur auquel la deuxième tension de signal (U_{S2}) est appliquée.
